# FASCICULE DE BREVET EUROPEEN

(11) **EP 3 018 827 B1**
(45) Date de publication et mention de la délivrance du brevet: **13.09.2017**
(21) Numéro de dépôt: 15193221.7
(22) Date de dépôt: 05.11.2015
(51) Int. Cl.: H03K 23/00, H03M 7/16

(54) **COMPTEUR DE GRAY ET CONVERTISSEUR ANALOGIQUE - NUMERIQUE UTILISANT UN TEL COMPTEUR**
GRAY-CODE-ZÄHLER UND ANALOG-DIGITALWANDLER, DER EINEN SOLCHEN ZÄHLER VERWENDET
GRAY COUNTER AND ANALOGUE-TO-DIGITAL CONVERTER USING SUCH A COUNTER

(30) Priorité: 07.11.2014 FR 1460765
(43) Date de publication de la demande: 11.05.2016
(73) Titulaire: Pyxalis, 38430 Moirans (FR)
(72) Inventeur: PINONCELY, Pierre-Adrien, 38450 MIRIBEL LANCHATRE (FR)
(74) Mandataire: Priori, Enrico

(56) Documents cités:
- WO-A1-01/33716
- US-A- 5 754 614
- US-A1- 2010 321 547

## Description

L'invention porte sur un compteur de Gray, ainsi que sur un convertisseur analogique-numérique à rampe utilisant un tel compteur.

Un compteur de Gray est un circuit numérique utilisé par exemple dans le document US 2010/032154 A1 qui effectue un comptage des impulsions présentes à son entrée selon un code de Gray.

Le code de Gray est un code binaire, décrit notamment dans le document US 2,632,058, qui présente l'avantage de ne nécessiter que la modification d'un seul bit lorsqu'un nombre est incrémenté ou décrémenté d'une unité. Cela n'est pas le cas du code binaire naturel dans lequel, par exemple, le passage de « 3 » (011) à « 4 » (100) nécessite le changement simultané de trois bits.

Dans un compteur binaire naturel, le fait de devoir modifier plusieurs bits à la fois lors d'un incrément ou un décrément peut conduire à l'apparition d'états transitoires indésirables, dus au fait que le délai de mise à jour des différents bits est différent. Ainsi, lors du passage de « 011 » (3) à « 100 » (4), il est possible que le bit de droite soit mis à jour le premier, puis le bit central et enfin le bit de gauche. Dans ce cas, le compteur passe brièvement par les états intermédiaires « 010 » (2) et « 000 » (0). Une lecture du compteur effectuée lors ce que ce dernier se trouve dans un tel état intermédiaire peut donc produire une erreur considérable. Cela conduit à utiliser les compteurs binaires naturels seulement dans des systèmes où on peut assurer une lecture synchrone, et à limiter la cadence de comptage. Les compteurs de Gray ne présentent pas un tel inconvénient : comme un seul bit change lors d'un incrément ou décrément, il n'y a pas d'état intermédiaire ; même si le compteur est lu avant que sa mise à jour soit achevée, l'erreur commis ne dépasse pas une unité.

Le tableau ci-dessous permet de comparer les codes de Gray et binaire naturel pour les nombres décimaux de 0 à 7 :

| Décimal | Gray | Binaire naturel |
|---|---|---|
| 0 | 000 | 000 |
| 1 | 001 | 001 |
| 2 | 011 | 010 |
| 3 | 010 | 011 |
| 4 | 110 | 100 |
| 5 | 111 | 101 |
| 6 | 101 | 110 |
| 7 | 100 | 111 |

On peut constater que pour incrementer un nombre en code de Gray il suffit d'inverser le bit le plus à droite possible qui conduit à un mot de code non utilisé en précédence. Ainsi pour passer de 0 (000) à 1 (001) on inverse le bit le plus à droite ; puis, pour passer de 1 (001) à 2 (011) on inverse le deuxième bit à partir de droite (car si on inversait le bit le plus à droite on retrouverait 000, déjà utilisé) et ainsi de suite.

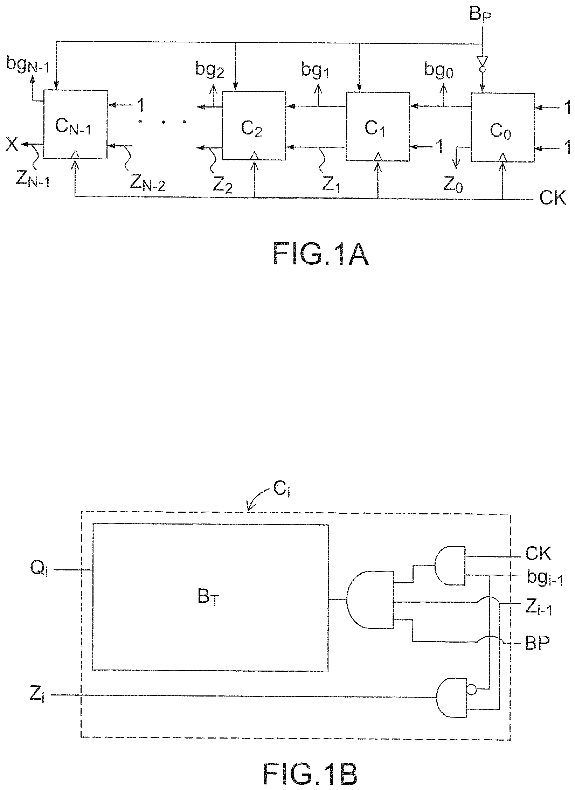

Les figures 1A et 1B illustrent le schéma d'un compteur de Gray connu de l'art antérieur. Comme le montre la figure 1A, un tel compteur se compose d'une pluralité de cellules C₀, C₁ ... C_{N-1} connectées en cascade, générant chacune un bit de Gray bg₀, bg₁ ... bg_{N-1} ainsi qu'un bit intermédiaire Z₀, Z₁ ... Z_{N-1}. Chaque cellule reçoit en entrée le bit de Gray et le bit intermédiaire générés par la cellule précédente (mais la première cellule reçoit en entrée deux « 1 » ; la deuxième cellule reçoit en entrée un « 1 » au lieu du bit intermédiaire Z₀ généré par la première cellule C₀ et la dernière cellule reçoit en entrée un « 1 » au lieu de l'avant-dernier bit de Gray), un signal d'horloge CK commun à toutes les cellules et un bit dit « de parité » BP qui change à chaque cycle d'horloge et qui vaut « 0 » quand la parité du mot bg₀, bg₁ ... bg_{N-1} vaut « 0 » et qui vaut « 1 » dans le cas contraire (le bit de BPI est inversé à l'entrée de la première cellule). La figure 1B illustre le schéma logique d'une cellule C(i), où la référence B_{T} indique une bascule de type «T».

Dans le circuit des figures 1A et 1B, le bit de Gray bgᵢ, généré par la cellule Ci, avec i>0, dépend de la valeur du bit de Gray bgᵢ₋₁ et du bit intermédiaire Zᵢ₋₁ générés par la cellule précédente, Cᵢ₋₁. On peut se rendre compte que la profondeur du « cône logique » en entrée de la cellule Cᵢ dépend de son ordre, i. Il est connu que la fréquence d'horloge d'un circuit numérique est limitée par son cône logique de profondeur maximale ; par conséquent, un compteur de Gray conventionnel est d'autant moins rapide que le nombre de cellules qui le composent est élevé.

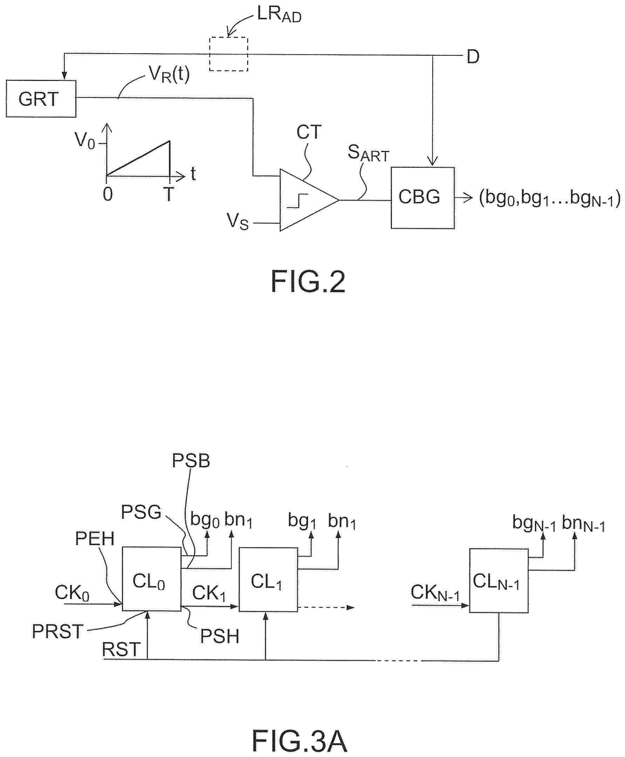

Les compteurs de Gray sont utilisés, entre autres, pour la réalisation de convertisseurs analogiques - numériques à rampe, dont la figure 2 montre un schéma de principe. Un convertisseur à rampe comprend un comparateur de tension CT recevant à une première entrée un signal analogique de tension Vs à numériser et à une seconde entrée une rampe de tension V_{R}(t)=V₀·t/T de durée T et avec V₀>Vₛ, générée par un circuit GRT. Le convertisseur comprend également un compteur binaire - de préférence de Gray - CBG, présentant une première entrée pour un signal de déclenchement et une seconde entrée pour un signal d'arrêt, ainsi qu'une sortie de comptage (bg₀ ...bg_{N-1}). Un signal de déclenchement D est fourni aussi bien au compteur qu'au générateur de rampe à des intervalles T ; ainsi le comptage démarre au début de la rampe. Le signal de sortie du comparateur, S_{ART} est fourni à la seconde entrée du compteur en tant que signal d'arrêt ; ainsi le comptage est arrêté lorsque la rampe V_{R}(t) dépasse le signal analogique d'entrée du convertisseur (dans certaines applications, l'arrêt du comptage peut être obtenu en transférant la sortie du compteur vers un élément de mémoire, sans arrêter le compteur ; cela permet d'utiliser un compteur commun à plusieurs convertisseurs, ayant chacun son propre comparateur et un générateur de rampe commun). On comprend aisément que la valeur affichée par le compteur lorsque le comptage est arrêté est proportionnel à la valeur de Vₛ. La résolution du convertisseur est d'autant plus élevée que le nombre de bits du compteur de Gray est élevé. D'après ce qui a été expliqué plus haut, on comprend qu'il faut accepter un compromis entre la rapidité du convertisseur - limitée par celle du compteur de Gray - et sa résolution.

L'invention vise à surmonter les inconvénients précités de l'art antérieur, et plus particulièrement à procurer un compteur de Gray dont la fréquence d'horloge - et donc la vitesse de comptage - ne dépend pas du nombre de bits. Un tel compteur convient particulièrement à être utilisé dans un convertisseur analogique - numérique à rampe, bien que d'autres applications soient également envisageables.

Conformément à l'invention un tel but est atteint grâce à une nouvelle architecture de compteur de Gray comprenant un enchaînement de cellules logiques couplées entre elles uniquement par l'intermédiaire d'un signal d'horloge.

Ainsi, un objet de l'invention est un compteur de Gray à N bit, avec N entier supérieur à 1, comprenant un enchaînement de N cellules logiques connectées en cascade, dans lequel chaque dite cellule logique comprend un port d'entrée pour une succession d'impulsions d'horloge et un circuit de génération d'un bit de comptage Gray ayant un port de sortie dudit bit de comptage Gray, caractérisé en ce que chaque dite cellule logique à l'exception tout au plus de la dernière cellule logique dudit enchainement comprend également un circuit de génération d'un signal d'horloge ayant un port de sortie d'horloge relié au port d'entrée de la cellule logique suivante, et en ce que :
- chaque dit circuit de génération d'un signal d'horloge est adapté pour autoriser le passage audit port de sortie d'horloge d'une impulsion d'horloge sur deux présente audit port d'entrée et pour interdire le passage de l'impulsion d'horloge suivante ;
- le circuit de génération d'un bit de comptage Gray de chaque dite cellule logique, à l'exception de la dernière cellule logique dudit enchainement, est adapté pour inverser la valeur du bit de comptage présent à son port de sortie à chaque fois que ledit circuit de génération d'un signal d'horloge de la cellule logique correspondante interdit le passage d'une dite impulsion d'horloge, et pour maintenir inchangée ladite valeur dans le cas contraire ; et
- le circuit de génération d'un bit de comptage Gray de ladite dernière cellule logique dudit enchainement est adapté pour inverser la valeur du bit de comptage présent à son port de sortie à chaque fois qu'une impulsion d'horloge est présente au port d'entrée de ladite dernière cellule logique.

Selon différents modes de réalisation d'un tel compteur de Gray:
- Le circuit de génération d'un bit de comptage Gray de chaque dite cellule logique, à l'exception tout au plus de la dernière cellule logique dudit enchainement, peut comprendre également une entrée pour un signal d'horloge reliée au port d'entrée de la cellule logique correspondante par l'intermédiaire d'une ligne de retard adaptée pour introduire un retard décroissant selon l'ordre de ladite cellule logique dans ledit enchaînement.
- Chaque dit circuit de génération d'un signal d'horloge peut comprendre : un commutateur configuré pour autoriser ou non le passage d'impulsions d'horloge dudit port d'entrée audit port de sortie d'horloge, et un circuit d'autorisation configuré pour générer un signal de pilotage dudit commutateur autorisant le passage d'une dite impulsion d'horloge sur deux et interdisant le passage de l'impulsion d'horloge suivante.
- Plus particulièrement, ledit circuit d'autorisation peut comprendre une bascule ayant un port d'entrée de donnée, un port d'entrée d'horloge relié au port d'entrée d'horloge de la cellule logique et un port de sortie, ledit port d'entrée de donnée étant connecté pour recevoir le complément du bit présent sur ledit port de sortie.
- Ledit circuit de génération d'un bit de comptage Gray de chaque dite cellule logique, à l'exception de la dernière cellule logique dudit enchainement, peut comprendre : un multiplexeur à deux entrées et une sortie, connecté pour recevoir sur une première entrée le bit de comptage Gray de la cellule logique correspondante et sur une deuxième entrée son complément, et configuré pour transférer à sa sortie le bit présent sur sa première entrée lorsque le circuit de génération d'un signal d'horloge de ladite cellule logique correspondante autorise le passage d'une dite impulsion d'horloge, et le bit présent sur sa deuxième entrée dans le cas contraire ; et une bascule ayant un port d'entrée de donnée, un port d'entrée d'horloge relié au port d'entrée de la cellule logique et un port de sortie relié au port de sortie du bit de comptage Gray de ladite cellule, ledit port d'entrée de donnée étant relié à la sortie dudit multiplexeur.
- Plus particulièrement, ledit circuit de génération d'un bit de comptage Gray de chaque dite cellule logique, à l'exception de la dernière cellule logique dudit enchainement, peut comprendre également un circuit de génération d'un signal de commande dudit multiplexeur comprenant une bascule ayant un port d'entrée de donnée, un port d'entrée d'horloge relié au port d'entrée de la cellule logique et un port de sortie, ledit port d'entrée de donnée étant connecté pour recevoir le complément du bit présent sur ledit port de sortie et ledit port de sortie étant connecté à une entrée de commande dudit multiplexeur.

Plus particulièrement encore, ledit circuit de génération d'un bit de comptage Gray de chaque dite cellule logique peut comprendre également un port de sortie, dit de comptage binaire naturel, relié au port de sortie dudit circuit de génération d'un signal de commande dudit multiplexeur.
- Ledit circuit de génération d'un bit de comptage Gray de ladite dernière cellule logique dudit enchainement peut comprendre une bascule ayant un port d'entrée de donnée, un port d'entrée d'horloge relié au port d'entrée de ladite cellule logique et un port de sortie relié au port de sortie du bit de comptage Gray de ladite cellule, ledit port d'entrée de donnée étant relié pour recevoir le complément du bit présent sur ledit port de sortie.
- Ladite ou chaque dite bascule de chaque dite cellule logique peut comporter une entrée de réinitialisation, toutes lesdites entrées de réinitialisation étant reliées ensemble pour recevoir un signal de réinitialisation commun.

Un autre objet de l'invention est un convertisseur analogique-numérique de type à rampe comprenant : un générateur d'une rampe de tension ; un comparateur de tension connecté de manière à recevoir à une première entrée ladite rampe de tension et à une deuxième entrée un signal de tension analogique à convertir, et adapté pour générer un signal d'arrêt lorsque le niveau de tension à sa première entrée dépasse celui à sa deuxième entrée et un compteur binaire configuré pour démarrer un comptage au début de la génération de ladite rampe et l'arrêter lors de la génération dudit signal d'arrêt, caractérisé en ce que ledit compteur binaire est un compteur de Gray tel que mentionné ci-dessus.

D'autres caractéristiques, détails et avantages de l'invention ressortiront à la lecture de la description faite en référence aux dessins annexés donnés à titre d'exemple et qui représentent, respectivement :
- Les figures 1A et 1B, décrites plus haut, un compteur de Gray connu de l'art antérieur ;
- La figure 2, également décrite plus haut, un convertisseur analogique-numérique du type à rampe, comprenant un compteur de Gray selon l'art antérieur ou selon l'invention ;
- Les figures 3A, 3B et 3C, le schéma logique d'un compteur de Gray selon un mode de réalisation de l'invention ; et
- La figure 4, un diagramme temporel (chronogramme) illustrant le fonctionnement d'un compteur de Gray selon un mode de réalisation de l'invention.

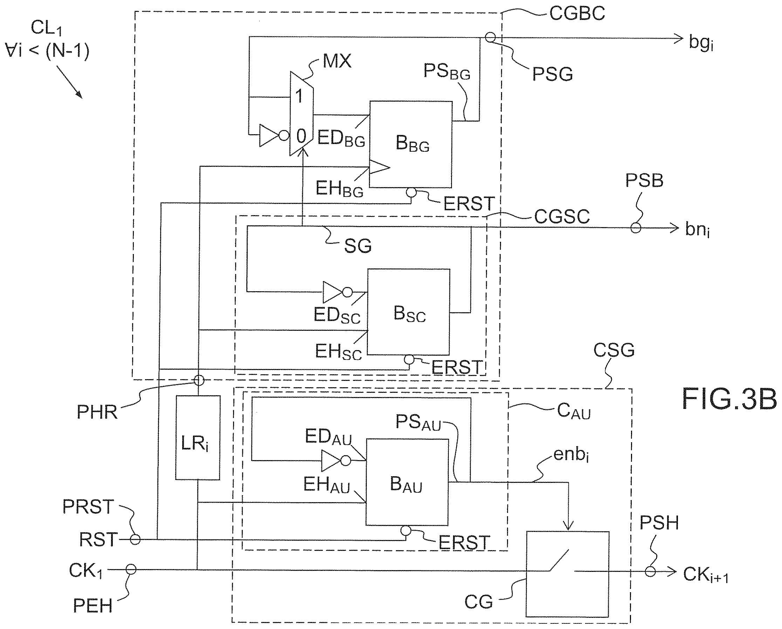

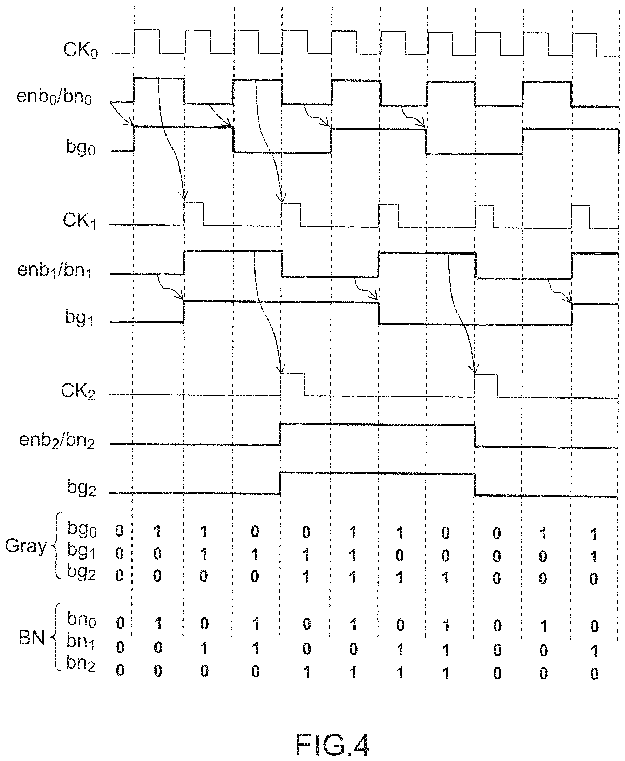

La figure 3A montre qu'un compteur de Gray selon l'invention se présente comme un enchaînement de N>1 cellules logiques CL₀ - CL_{N-1} ayant chacune un port d'entrée PEH pour un signal d'horloge en entrée (CKᵢ pour la cellule CLᵢ), un port de sortie PSH pour un signal d'horloge en sortie (CKᵢ₊₁ pour la cellule CLᵢ) et un port de sortie PSG pour un bit de comptage de Gray (bgᵢ pour la cellule CLᵢ). La dernière cellule de l'enchaînement peut ne pas comporter de port de sortie pour le signal d'horloge. Chaque cellule peut également comporter un port de sortie PSB pour un bit de comptage binaire « naturel » (bnᵢ pour la cellule CLᵢ) qui, comme sera expliqué plus loin, à l'aide des figures 3B et 4, est généré comme « sous-produit » du processus de comptage de Gray mis en oeuvre pour chaque cellule. Avantageusement, chaque cellule comprend également un port d'entrée PRST pour un signal de remise à zéro, typiquement commun à toutes les cellules.

Les cellules logiques du compteur de la figure 3A sont chaînées entre elles uniquement par l'intermédiaire du signal d'horloge. En effet, le signal d'horloge de sortie de chaque cellule logique (sauf évidemment la dernière) est fourni à la cellule suivante en tant que signal d'horloge d'entrée. Comme cela sera expliqué plus loin, à l'aide des figures 3B et 4, chaque cellule logique fournit à son port de sortie PSH un signal d'horloge présentant une fréquence égale à la moitié de celle du signal d'horloge présent à son port d'entrée PEH. Avantageusement, cette division de fréquence se fait en ne permettant qu'à une impulsion d'horloge sur deux de traverser la cellule, et en laissant la largeur de ces impulsions inchangées. Ainsi, le rapport cyclique du signal d'horloge - typiquement égal à 50% à l'entrée du compteur (signal CK₀) - diminue au fur et à mesure que l'on avance dans l'enchainement de cellules. On remarquera que cela présente l'avantage de réduire la consommation de puissance.

Le fait que les cellules n'interagissent que par l'intermédiaire du signal d'horloge, sans partager e.g. un signal de parité, minimise la logique nécessaire dans chaque cellule, augmentant sa fréquence de fonctionnement maximale. On peut estimer que, à technologie égale, le gain de fréquence maximale par rapport à une architecture conventionnelle (e.g. figures 1A et 1B) est de l'ordre de 1,5.

La figure 3B illustre le schéma logique d'une cellule logique CLᵢ du compteur de la figure 3A autre que la dernière cellule, CL_{N-1}.

Cette cellule comprend deux circuits :
- un circuit de génération d'horloge CSG qui prend le signal d'horloge CKᵢ du port d'entrée PEH, génère le signal d'horloge CKᵢ₊₁ et le rend disponible sur le port de sortie PSH ; et
- un circuit de génération d'un bit de comptage Gray CGBC qui prend le signal d'horloge CKᵢ du port d'entrée PEH, génère le bit de comptage Gray bgᵢ et, optionnellement, le bit de comptage binaire naturel bnᵢ.

Le circuit de génération d'horloge CGH comprend à son tour :
- un commutateur d'horloge CG connecté entre le port d'entrée PEH et le port de sortie PSH pour autoriser ou interdire le passage d'une impulsion d'horloge ; et
- un circuit de génération de signal d'autorisation CAU qui génère un signal de pilotage du commutateur, ou « d'autorisation », référencé par enbᵢ sur la figure.

Le signal d'autorisation enbᵢ prend une première valeur binaire (par exemple zéro) au démarrage du circuit, puis change de valeur binaire à chaque impulsion d'horloge présente à l'entrée PEH. Cela peut être obtenu à l'aide d'un circuit CAU très simple, constitué par exemple par une bascule B_{AU} ayant une entrée d'horloge EH_{AU} reliée au port d'entrée PEH, une entrée de donnée ED_{AU} et une sortie de donnée PS_{AU} rebouclée sur l'entrée par l'intermédiaire d'un inverseur (porte logique « NON »). Le signal enbᵢ est prélevé sur la sortie de donnée.

Le commutateur CG autorise ou interdit le passage d'une impulsion d'horloge présente à son entrée en fonction de la valeur du signal d'autorisation enbᵢ; plus précisément, il interdit le passage de l'impulsion d'horloge lorsque enbᵢ présente ladite première valeur binaire (0) et l'autorise lorsque enbᵢ présente une seconde valeur binaire opposée à la première (1). Avantageusement, le commutateur est une porte d'horloge (« clock gater » en anglais), voir par exemple l'article de J. Kathuria et al. « A Review of Clock Gating Techniques », MIT International Journal of Electronics and Communication Engineering, Vol. 1, No. 2, pages 106 - 114 (2011).

Le circuit de génération d'un bit de comptage de Gray CGBC, comprend une bascule B_{BG} ayant une entrée d'horloge EH_{BG} reliée au port d'entrée PEH, une entrée de donnée ED_{BG} et une sortie de donnée PS_{BG} rebouclée sur l'entrée par l'intermédiaire d'un multiplexeur MX et un inverseur (porte logique « NON »). Le bit de comptage de Gray bgᵢ est prélevé sur la sortie de donnée PS_{BG}.

Le multiplexeur MX est piloté de telle sorte que la sortie de la bascule soit rebouclée sur son entrée sans inversion lorsque le commutateur autorise le passage d'un signal d'horloge (et donc enbᵢ prend sa seconde valeur binaire, « 1 » dans l'exemple considéré) et avec inversion lorsque le commutateur interdit le passage d'un signal d'horloge (et donc enbᵢ prend sa première valeur binaire, « 0 » dans l'exemple considéré). En principe, le multiplexeur MX pourrait être piloté directement par le signal enbᵢ; toutefois, pour des raisons qui seront clarifiées ci-après il est préférable qu'il le soit par un signal de commande SC généré de manière indépendante par une bascule B_{SC} ayant une entrée d'horloge EH_{SC} reliée au port d'entrée PEH, une entrée de donnée ED_{SC} et une sortie de donnée PS_{SC} rebouclée sur l'entrée par l'intermédiaire d'un inverseur (porte logique « NON »). Il s'agit en pratique d'une réplique du circuit d'autorisation CAU.

La raison pour laquelle il est préférable dupliquer le circuit d'autorisation est la suivante. Le commutateur d'horloge CG introduit un retard, et donc une latence différente à l'entrée de chaque cellule. Si on ne prenait pas de précautions, les bits de comptage de Gray ne seraient pas mis à jour en même temps et le compteur passerait par des états intermédiaires incorrects dans lesquels les premiers M bits de comptage (M<N) ont été mis à jour, mais pas les derniers (N-M). A la limite, pour N suffisamment élevé, le temps de propagation d'une impulsion d'horloge à travers le compteur deviendrait supérieur à la période de CK₀, et le compteur cesserait de fonctionner correctement. Ainsi, la fréquence maximale de fonctionnement du compteur serait une fonction décroissante de N, comme dans le cas de l'art antérieur.

Pour éviter cela, il est proposé d'introduire une ligne de retard LRᵢ - par exemple constituée par un nombre paire d'inverseurs reliés en cascade - entre le port d'entrée d'horloge PEH de la cellule CLᵢ et son circuit de génération d'un bit de comptage de Gray, CGBC ; ce dernier circuit reçoit ainsi un signal d'horloge retardé à un port d'entrée PHR. Le retard introduit par la ligne LRᵢ est idéalement égal au retard cumulé introduit par les commutateurs d'horloge de toutes les cellules en aval de la cellule CLᵢ (c'est-à-dire les cellules CLᵢ₊₁ à CL_{N-1}). Ainsi, tous les bits de comptage commutent en même temps, avec un retard (« latence »), par rapport à l'arrivée de la première impulsion d'horloge à l'entre PEH de la cellule CL₀, dépendant de N. Il est très important de souligner que la présence des lignes de retard rend la fréquence de fonctionnement du compteur tout à fait indépendante du nombre de bits de comptage, N. Seule la latence est une fonction croissante de N, mais cela est beaucoup moins gênant. Si, par exemple, on souhaite utiliser un compteur selon l'invention et présentant un nombre de bit élevé, dans le convertisseur analogique - numérique de la figure 2, il suffira de prévoir une ligne de retard sur la branche du signal de déclenchement D dirigée vers le générateur de rampe GRT afin de compenser la latence du compteur (représentée en trait pointillé sur la figure 2, référence LR_{AD}). En variante, il est possible de ne pas compenser cette latence, ou de la compenser de manière incomplète, ce qui entraine un décalage de la sortie du convertisseur par rapport à sa valeur attendue, puis de corriger numériquement ce décalage.

En variante, on peut ne pas dupliquer le circuit d'autorisation, et donc faire l'économie de la bascule B_{SC} et de l'inverseur qui lui est associé. Dans ce cas, cependant, la compensation du retard ne peut qu'être partielle, car la bascule B_{AU} doit être équilibrée avec le commutateur CG, tandis que B_{SC} doit l'être avec la sortie ; ces deux conditions ne peuvent pas être satisfaites simultanément par une seule et même bascule. Cette solution ne convient donc que pour des valeurs pas trop élevées de N.

En variante, la compensation pourrait être obtenue sans dupliquer le circuit d'autorisation, en pilotant le multiplexeur MX par une version de enbᵢ retardée par une ligne de retard opportunément dimensionnée. Une telle solution peut s'avérer plus consommatrice de surface de silicium que la duplication du circuit d'autorisation, tout en étant moins fiable car son fonctionnement repose sur l'équilibrage entre deux lignes de retard.

Enfin, la question de la compensation du retard - et de la duplication du circuit d'autorisation - peut être ignorée si N est suffisamment faible par rapport à la fréquence de fonctionnement.

A titre d'exemple on considère une réalisation du compteur selon l'invention sous la forme d'un circuit intégré en technologie électronique CMOS à 180 nm, avec une fréquence d'horloge égale à 700 MHz (période d'horloge : 1,428 ns). Chaque commutateur d'horloge est réalisé par une porte ET ayant les signaux CKᵢ et enbᵢ à ses entrées et introduit un retard de 200 ps. Dans ces conditions, pour N=15, la latence est de 6 ns. Sans compensation du retard, le compteur ne pourrait pas fonctionner car la cellule CL₀ recevrait quatre impulsions d'horloge à son entrée avant que la première impulsion d'horloge ne parvienne à la dernière cellule. Par contre, une latence de 6 ns est généralement acceptable. Dans le cas d'un comptage à 4 ou 5 bits, on pourrait se passer de compensation du retard.

Le signal de commande SC (ou enbᵢ, s'il n'y a pas de duplication du circuit d'autorisation) peut être fourni au port de sortie PSB de la cellule CLᵢ, si ce dernier est présent. Il est possible de démontrer qu'il constitue un bit de comptage binaire naturel, bnᵢ. On obtient ainsi, sans coût supplémentaire (sauf l'ajout d'une sortie par cellule) un comptage dual, en code de Gray et en code binaire naturel. Bien entendu, le comptage en code binaire naturel présente l'inconvénient précité, lié au changement de plusieurs bits lors d'un incrément.

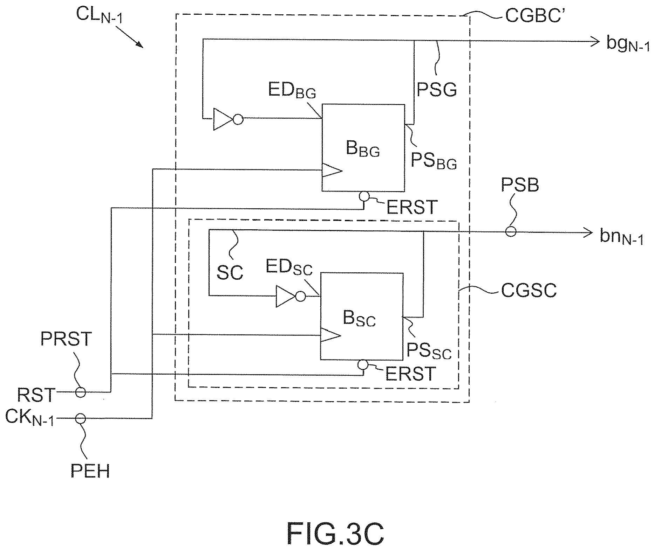

La dernière cellule logique du compteur CL_{N-1}, est différente des autres, et son schéma est donné sur la figure 3C. Comme il s'agit de la dernière cellule à recevoir une impulsion d'horloge, elle n'a pas besoin d'une ligne de retard ; en outre, comme elle ne doit fournir un signal d'horloge à aucune cellule logique en aval, elle peut ne pas comporter de circuit de génération d'horloge. En outre, son circuit de génération d'un bit de comptage de Gray, CGBC', ne comporte pas de multiplexeur : la sortie PS_{BG} de la bascule B_{BG} est simplement rebouclée sur son entrée ED_{BG} par l'intermédiaire d'un inverseur.

Le signal de réinitialisation RST est fourni à une entrée de réinitialisation ERST de toutes les bascules de chaque cellule logique.

La figure 4 illustre le fonctionnement du compteur des figures 3A, 3B et 3C, en considérant N=3. Il s'agit d'un chronogramme montrant les formes d'onde des signaux CK₀, enb₀ (ou bn₀), bg₀, CK₁, enb₁ (ou bn₁), bg₁, CK₂, enb₂ (ou bn₂) et bg₂, ainsi que les mots formés par les bits de comptage de Gray (Gray= bg₀ bg₁ bg₂) et naturel (BN= bn₀ bn₁ bn₂). Les retards introduits par les commutateurs d'horloge sont supposés négligeables dans un souci de simplicité.

L'architecture de compteur proposée se prête particulièrement à une réalisation intégrée, même si une réalisation à composants discrets est également possible.

L'invention a été décrite en référence à un mode de réalisation particulier, mais des variantes sont possibles. Par exemple, l'homme du métier est en mesure d'envisager des réalisations différentes des circuits de génération des signaux d'horloge et du circuit de génération des bits de comptage Gray présentant les fonctionnalités requises.

## Revendications

1. Compteur de Gray à N bit, avec N entier supérieur à 1, comprenant un enchaînement de N cellules logiques (CL₀ - CL_{N-1}) connectées en cascade, dans lequel chaque dite cellule logique comprend un port d'entrée (PEH) pour une succession d'impulsions d'horloge (CK₀ - CK_{N-1}) et un circuit de génération (CGBC, CGBC') d'un bit de comptage Gray (bg₀ - bg_{N-1}) ayant un port de sortie dudit bit de comptage Gray (PSG), **caractérisé en ce que** chaque dite cellule logique à l'exception tout au plus de la dernière cellule logique dudit enchainement comprend également un circuit de génération d'un signal d'horloge (CGH) ayant un port de sortie d'horloge (PSH) relié au port d'entrée de la cellule logique suivante, et **en ce que** :
- chaque dit circuit de génération d'un signal d'horloge est adapté pour autoriser le passage audit port de sortie d'horloge d'une impulsion d'horloge sur deux présente audit port d'entrée et pour interdire le passage de l'impulsion d'horloge suivante ;
- le circuit de génération (CGBC) d'un bit de comptage Gray de chaque dite cellule logique, à l'exception de la dernière cellule logique dudit enchainement, est adapté pour inverser la valeur du bit de comptage (bgᵢ) présent à son port de sortie à chaque fois que ledit circuit de génération d'un signal d'horloge de la cellule logique correspondante interdit le passage d'une dite impulsion d'horloge, et pour maintenir inchangée ladite valeur dans le cas contraire ; et
- le circuit de génération (CGBC') d'un bit de comptage Gray de ladite dernière cellule logique dudit enchainement est adapté pour inverser la valeur du bit de comptage (bg_{N-1}) présent à son port de sortie à chaque fois qu'une impulsion d'horloge est présente au port d'entrée de ladite dernière cellule logique.

2. Compteur de Gray selon la revendication 1 dans lequel le circuit de génération d'un bit de comptage Gray de chaque dite cellule logique, à l'exception tout au plus de la dernière cellule logique dudit enchainement, comprend également une entrée (PHR) pour un signal d'horloge reliée au port d'entrée (PEH) de la cellule logique correspondante par l'intermédiaire d'une ligne de retard (LR) adaptée pour introduire un retard décroissant selon l'ordre de ladite cellule logique dans ledit enchaînement.

3. Compteur de Gray selon l'une des revendications précédentes dans lequel chaque dit circuit de génération d'un signal d'horloge comprend :
- un commutateur (CG) configuré pour autoriser ou non le passage d'impulsions d'horloge dudit port d'entrée audit port de sortie d'horloge, et
- un circuit d'autorisation (CAU) configuré pour générer un signal de pilotage (enbᵢ) dudit commutateur autorisant le passage d'une dite impulsion d'horloge sur deux et interdisant le passage de l'impulsion d'horloge suivante.

4. Compteur de Gray selon la revendication 3 dans lequel ledit circuit d'autorisation comprend une bascule (B_{AU}) ayant un port d'entrée de donnée (ED_{AU}), un port d'entrée d'horloge (EH_{AU}) relié au port d'entrée d'horloge (PEH) de la cellule logique et un port de sortie (PS_{AU}), ledit port d'entrée de donnée étant connecté pour recevoir le complément du bit présent sur ledit port de sortie.

5. Compteur de Gray selon l'une des revendications précédentes dans lequel ledit circuit de génération (CGBC) d'un bit de comptage Gray de chaque dite cellule logique, à l'exception de la dernière cellule logique dudit enchainement, comprend :
- un multiplexeur (MX) à deux entrées et une sortie, connecté pour recevoir sur une première entrée le bit de comptage Gray (bgᵢ) de la cellule logique correspondante et sur une deuxième entrée son complément, et configuré pour transférer à sa sortie le bit présent sur sa première entrée lorsque le circuit de génération d'un signal d'horloge de ladite cellule logique correspondante autorise le passage d'une dite impulsion d'horloge, et le bit présent sur sa deuxième entrée dans le cas contraire ; et
- une bascule (B_{BG}) ayant un port d'entrée de donnée (ED_{BG}), un port d'entrée d'horloge (EH_{BG}) relié au port d'entrée de la cellule logique et un port de sortie (PS_{BG}) relié au port de sortie du bit de comptage Gray de ladite cellule, ledit port d'entrée de donnée étant relié à la sortie dudit multiplexeur.

6. Compteur de Gray selon la revendication 5 dans lequel ledit circuit de génération d'un bit de comptage Gray de chaque dite cellule logique, à l'exception de la dernière cellule logique dudit enchainement, comprend également un circuit de génération d'un signal de commande (CGSC) dudit multiplexeur comprenant une bascule (B_{SC}) ayant un port d'entrée de donnée (ED_{SC}), un port d'entrée d'horloge (EH_{SC}) relié au port d'entrée de la cellule logique et un port de sortie (PS_{SC}), ledit port d'entrée de donnée étant connecté pour recevoir le complément du bit présent sur ledit port de sortie et ledit port de sortie étant connecté à une entrée de commande dudit multiplexeur.

7. Compteur de Gray selon la revendication 6 dans lequel ledit circuit de génération d'un bit de comptage Gray de chaque dite cellule logique comprend également un port de sortie (PSB), dit de comptage binaire naturel, relié au port de sortie dudit circuit de génération d'un signal de commande dudit multiplexeur.

8. Compteur de Gray selon l'une des revendications 5 à 7 dans lequel ledit circuit de génération (CGBC') d'un bit de comptage Gray de ladite dernière cellule logique dudit enchainement comprend une bascule (B_{BG}) ayant un port d'entrée de donnée (ED_{BG}), un port d'entrée d'horloge relié au port d'entrée de ladite cellule logique et un port de sortie (PS_{BG}) relié au port de sortie du bit de comptage Gray de ladite cellule, ledit port d'entrée de donnée étant relié pour recevoir le complément du bit présent sur ledit port de sortie.

9. Compteur de Gray selon l'une des revendications 4, 6 ou 8 dans lequel ladite ou chaque dite bascule de chaque dite cellule logique comporte une entrée de réinitialisation (ERST), toutes lesdites entrées de réinitialisation étant reliées ensemble pour recevoir un signal de réinitialisation (RST) commun.

10. Convertisseur analogique-numérique de type à rampe comprenant : un générateur d'une rampe de tension (GRT) ; un comparateur de tension (CT) connecté de manière à recevoir à une première entrée ladite rampe de tension (V_{R}) et à une deuxième entrée un signal de tension analogique (V_{S}) à convertir, et adapté pour générer un signal d'arrêt (S_{ART}) lorsque le niveau de tension à sa première entrée dépasse celui à sa deuxième entrée et un compteur binaire (CBG) configuré pour démarrer un comptage au début de la génération de ladite rampe et l'arrêter lors de la génération dudit signal d'arrêt, **caractérisé en ce que** ledit compteur binaire est un compteur de Gray selon l'une des revendications précédentes.

## Patentansprüche

1. N-Bit-Gray-Zähler, wobei N eine Ganzzahl größer als 1 ist, die eine Verkettung von N Logikzellen (CL₀ - CL_{N-1}) umfasst, die in Kaskade geschaltet sind, wobei jede der Logikzellen einen Eingangsport (PEH) für eine Abfolge von Taktimpulsen (CK₀ - CK_{N-1}) und eine Schaltung zur Erzeugung (CGBC, CGBC') eines Gray-Zählungs-Bits (bg₀ - bg_{N-1}) umfasst, die einen Ausgangsport des Gray-Zählungs-Bits (PSG) hat, **dadurch gekennzeichnet, dass** jede der Logikzellen höchstens mit Ausnahme der letzten Logikzelle der Verkettung auch eine Schaltung zur Erzeugung eines Taktsignals (CGH) umfasst, die einen Takt-Ausgangsport (PSH) umfasst, der mit dem Eingangsport der nächsten Logikzelle verbunden ist, und dass:
- jede Schaltung zur Erzeugung eines Taktsignals dazu angepasst ist, dem Takt-Ausgangsport den Durchgang jedes zweiten beim Eingangsport vorhandenen Taktimpulses freizugeben und den Durchgang des folgenden Taktimpulses zu verbieten;
- die Schaltung zur Erzeugung (CGBC) eines Gray-Zählungs-Bits jeder der Logikzellen, mit Ausnahme der letzten Logikzelle der Verkettung, dazu angepasst ist, den Wert des Zählungs-Bits (bgᵢ), das an seinem Ausgangsport vorliegt, jedes Mal, wenn die Schaltung zur Erzeugung eines Taktsignals der entsprechenden Logikzelle einem der Taktimpulse den Durchgang verbietet, umzukehren, und andernfalls den Wert unverändert zu lassen; und
- die Schaltung zur Erzeugung (CGBC') eines Gray-Zählungs-Bits der Logikzelle der Verkettung dazu angepasst ist, den Wert des Zählungs-Bits (bg_{N-1}), das an seinem Ausgangsport vorliegt, jedes Mal umzukehren, wenn ein Taktimpuls am Eingangsport der letzten Logikzelle vorliegt.

2. Gray-Zähler nach Anspruch 1, wobei die Schaltung zur Erzeugung eines Gray-Zählungs-Bits von jeder der Logikzellen höchstens mit Ausnahme der letzten Logikzelle der Verkettung, auch einen Eingang (PHR) für ein Taktsignal umfasst, das mit dem Eingangsport (PEH) der entsprechenden Logikzelle mittels einer Verzögerungsleitung (LR) geschaltet ist, die zum Einführen einer abnehmenden Verzögerung in der Reihenfolge der Logikzelle in der Verkettung angepasst ist.

3. Gray-Zähler nach einem der vorstehenden Ansprüche, wobei jede der Schaltungen zur Erzeugung eines Taktsignals folgendes umfasst:
- einen Schalter (CG), der dazu angepasst ist, den Durchgang der Taktimpulse des Eingangsports am Takt-Ausgangsport freizugeben oder nicht, und
- einen Entsperrschaltkreis (CAU), der konfiguriert ist, ein Steuersignal (enbᵢ) des Schalters zu erzeugen, das jedem zweiten Taktimpuls den Durchgang freigibt und dem folgenden den Durchgang verbietet.

4. Gray-Zähler nach Anspruch 3, wobei der Entsperrschaltkreis ein Flipflop (B_{AU}) umfasst, das einen Daten-Eingangsport (ED_{AU}), einen Takt-Eingangsport (EH_{AU}), der mit dem Takt-Eingangsport (PEH) der Logikzelle verbunden ist, und einen Ausgangsport (PS_{AU}) aufweist, wobei der Daten-Eingangsport geschaltet ist, um das Komplement des Bits auf dem Ausgangsport zu erhalten.

5. Gray-Zähler nach einem der vorstehenden Ansprüche, wobei die Schaltung zur Erzeugung (CGBC) eines Gray-Zählungs-Bits jeder der Logikzellen mit Ausnahme der letzten Logikzelle der Verkettung, folgendes umfasst:
- einen Multiplexer (MX) mit zwei Eingängen und einem Ausgang, der verbunden ist, um auf einem ersten Eingang das Gray-Zählungs-Bit (bgᵢ) der entsprechenden Logikzelle und auf einem zweiten Eingang sein Komplement zu erhalten, und konfiguriert ist, an seinem Ausgang das vorliegende Bit auf seinen ersten Eingang zu übertragen, wenn die Schaltung zur Erzeugung eines Taktsignals der entsprechenden Logikzelle den Durchgang eines Taktimpulses freigibt, und andernfalls das vorliegende Bit auf seinen zweiten Eingang; und
- ein Flipflop (B_{BG}), das einen Daten-Eingangsport (ED_{BG}), einen Takt-Eingangsport (EH_{BG}), der mit dem Takt-Eingangsport der Logikzelle verbunden ist, und einen Ausgangsport (PS_{BG}), der mit dem Ausgangsport des Gray-Zählungs-Bits der Zelle verbunden ist, aufweist, wobei der Daten-Eingangsport mit dem Ausgang des Multiplexers verbunden ist.

6. Gray-Code-Zähler nach Anspruch 5, wobei die Schaltung zur Erzeugung eines Gray-Zählungs-Bits von jeder der Logikzellen, mit Ausnahme der letzten Logikzelle der Verkettung, auch eine Schaltung zur Erzeugung eines Steuersignals (CGSC) des Multiplexers umfasst, die ein Flipflop (B_{SC}), das einen Daten-Eingangsport (ED_{SC}), einen Takt-Eingangsport (EH_{SC}), der mit dem Takt-Eingangsport der Logikzelle verbunden ist, und einen Ausgangsport (PS_{SC}) umfasst, wobei der Daten-Eingangsport geschaltet ist, um das Komplement des auf dem Ausgangsport vorliegenden Bits zu erhalten, und wobei der Ausgangsport mit einem Steuereingang des Multiplexers verbunden ist.

7. Gray-Zähler nach Anspruch 6, wobei die Schaltung zur Erzeugung eines Gray-Zählungs-Bits von jeder der Logikzellen auch einen Ausgangsport (PSB) umfasst, der als natürlich binär bezeichnet wird, der mit dem Ausgangsport der Schaltung zur Erzeugung eines Steuersignals des Multiplexers verbunden ist.

8. Gray-Zähler nach einem der Ansprüche 5 bis 7, wobei die Schaltung zur Erzeugung (CGBC') eines Gray-Zählungs-Bits der letzten Logikzelle der Verkettung ein Flipflop (B_{BG}) umfasst, das einen Daten-Eingangsport (ED_{BG}), einen Takt-Eingangsport, der mit dem Eingangsport der Logikzelle verbunden ist, und einen Ausgangsport (PS_{BG}), der mit dem Ausgangsport des Gray-Zählungs-Bits der Zelle verbunden ist, umfasst, wobei der Daten-Eingangsport geschaltet ist, um das Komplement des auf dem Ausgangsport vorliegenden Bits zu erhalten.

9. Gray-Zähler nach einem der Ansprüche 4, 6 oder 8, wobei das oder jedes Flipflop jeder Logikzelle einen Rücksetzungseingang (ERST) umfasst, wobei alle Rücksetzungseingänge miteinander verbunden sind, um ein gemeinsames Rücksetzungssignal (RST) zu erhalten.

10. Analog-Digital-Wandler vom Rampen-Typ, umfassend: einen Spannungsrampengenerator (GRT); einen Spannungskomparator (CT), der verbunden ist, um bei einem ersten Eingang die Spannungsrampe (V_{R}) und bei einem zweiten Eingang ein zu konvertierendes analoges Spannungssignal (V_{S}) zu erhalten, und der angepasst ist, um ein Haltesignal (S_{ART}) zu erzeugen, wenn der Spannungspegel bei seinem ersten Eingang denjenigen bei seinem zweiten Eingang übersteigt, und einen Binärzähler (CBG), der konfiguriert ist, eine Zählung zu Beginn der Erzeugung der Rampe zu starten und sie zu stoppen, wenn das Haltesignal erzeugt wird, **dadurch gekennzeichnet, dass** der Binärzähler ein Gray-Zähler nach einem der vorstehenden Ansprüche ist.

## Claims

1. N-bit Gray counter, with N an integer greater than 1, comprising a string of N logic cells (CL₀ - CL_{N-1}) connected in cascade, in which each said logic cell comprises an input port (PEH) for a succession of clock pulses (CK₀ - CK_{N-1}) and a circuit (CGBC, CGBC') for generating a Gray count bit (bg₀ - bg_{N-1}) having an output port for said Gray count bit (PSG), **characterised in that** each said logic cell, except at most the last logic cell of said string also comprises a circuit for generating a clock signal (CGH) having a clock output port (PSH) linked to the input port of the following logic cell, and **in that**:
- each said circuit for generating a clock signal is adapted for authorising the passage to said clock output port of one clock pulse out of two present at said input port and for prohibiting the passage of the following clock pulse;
- the circuit (CGBC) for generating a Gray count bit for each said logic cell, with the exception of the last logic cell of said string, is adapted for inverting the value of the count bit (bgi) present at its output port each time that said circuit for generating a clock signal of the corresponding logic cell prohibits the passage of a said clock pulse, and for maintaining said value unchanged in the converse case; and
- the circuit (CGBC') for generating a Gray count bit for said last logic cell of said string is adapted for inverting the value of the count bit (bgN-1) present at its output port each time that a clock pulse is present at the input port of said last logic cell.

2. Gray counter according to claim 1, in which the circuit for generating a Gray count bit for each said logic cell, except at most the last logic cell of said string, also comprises a clock signal input (PHR) linked to the input port (PEH) of the corresponding logic cell by way of a delay line (LR) adapted for introducing a delay which decreases according to the order of said logic cell in said string.

3. Gray counter according to any one of the preceding claims, in which each said circuit for generating a clock signal comprises:
- a switch (CG) configured to authorise or not the passage of clock pulses from said input port to said clock output port, and
- an authorisation circuit (CAU) configured to generate a drive signal (enbᵢ) for said switch authorising the passage of a said clock pulse out of two and prohibiting the passage of the following clock pulse.

4. Gray counter according to claim 3, in which said authorisation circuit comprises a flip-flop (B_{AU}) having a data input port (ED_{AU}), a clock input port (EH_{AU}) linked to the clock input port (PEH) of the logic cell and an output port (PS_{AU}), said data input port being connected so as to receive the complement of the bit present on said output port.

5. Gray counter according to any one of the preceding claims, in which said circuit (CGBC) for generating a Gray count bit for each said logic cell, with the exception of the last logic cell of said string, comprises:
- a multiplexer (MX) with two inputs and an output, connected to receive on a first input the Gray count bit (bgi) of the corresponding logic cell and on a second input its complement, and configured to transfer to its output the bit present on its first input when the circuit for generating a clock signal of said corresponding logic cell authorises the passage of a said clock pulse, and the bit present on its second input in the converse case; and
- a flip-flop (B_{BG}) having a data input port (ED_{BG}), a clock input port (EH_{BG}) linked to the input port of the logic cell and an output port (PS_{BG}) linked to the output port for the Gray count bit for said cell, said data input port being linked to the output of said multiplexer.

6. Gray counter according to claim 5, in which said circuit for generating a Gray count bit for each said logic cell, except the last logic cell of said string, also comprises a circuit for generating a control signal (CGSC) for said multiplexer comprising a flip-flop (Bsc) having a data input port (EDsc), a clock input port (EHsc) linked to the input port of the logic cell and an output port (PS_{SC}), said data input port being connected so as to receive the complement of the bit present on said output port and said output port being connected to a control input of said multiplexer.

7. Gray counter according to claim 6, in which said circuit for generating a Gray count bit for each said logic cell also comprises an output port, called natural binary counting output port (PSB), linked to the output port of said circuit for generating a control signal for said multiplexer.

8. Gray counter according to any one of claims 5 to 7, in which said generating circuit (CGBC') for generating a Gray count bit for said last logic cell of said string comprises a flip-flop (B_{BG}) having a data input port (ED_{BG}), a clock input port linked to the input port of said logic cell and an output port (PS_{BG}) linked to the output port for the Gray count bit for said cell, said data input port being linked so as to receive the complement of the bit present on said output port.

9. Gray counter according to any one of claims 4, 6 or 8, in which said or each said flip-flop of each said logic cell comprises a reinitialisation input (ERST), all said reinitialisation inputs being linked together so as to receive a common reinitialisation signal (RST).

10. Analogue-digital converter of ramp type comprising: a generator of a voltage ramp (GRT); a voltage comparator (CT) connected so as to receive at a first input said voltage ramp (V_{R}) and at a second input an analogue voltage signal (V_{S}) to be converted, and adapted for generating a stopping signal (S_{ART}) when the voltage level at its first input exceeds that at its second input and a binary counter (CBG) configured to start a count at the commencement of the generation of said ramp and stop it upon the generation of said stopping signal, **characterised in that** said binary counter is a Gray counter according to any one of the preceding claims.
